# FASCICULE DE BREVET EUROPEEN

(11) **EP 3 089 211 B1**
(45) Date de publication et mention de la délivrance du brevet: **15.03.2023**
(21) Numéro de dépôt: 16166445.3
(22) Date de dépôt: 21.04.2016
(51) Int. Cl.: H01L 21/54, H01L 21/56, H01L 23/24, H01L 23/29, H01L 23/31, H01L 23/552, H01L 23/66, H01L 21/60, H01L 23/36, H01L 23/498, H05K 1/18

(54) **PROCEDE D'ENCAPSULATION D'UN CIRCUIT ELECTRONIQUE**
VERPACKUNGSVERFAHREN EINES ELEKTRONISCHEN SCHALTKREISES
METHOD FOR PACKAGING AN ELECTRONIC CIRCUIT

(30) Priorité: 30.04.2015 FR 1500912
(43) Date de publication de la demande: 02.11.2016
(73) Titulaire: THALES, 92400 Courbevoie (FR)
(72) Inventeur: KERTESZ, Philippe, 92500 RUEIL MALMAISON (FR)
(74) Mandataire: Atout PI Laplace

(56) Documents cités:
- EP-A2- 0 872 888
- US-A- 5 796 170
- US-A1- 2006 042 078
- US-A1- 2008 017 409
- US-A1- 2011 147 920

## Description

La présente invention concerne un procédé de packaging d'un composant hyperfréquence résistant à l'humidité.

L'invention se situe notamment dans le domaine du packaging microélectronique hyperfréquence, en particulier pour réaliser des boîtiers hyperfréquence comportant un blindage intégré et résistant à l'humidité. Ces boîtiers sont par exemple utilisés dans des équipements hyperfréquence complexes tels que des radars aéroportés à balayage électronique. Plus généralement, le domaine d'application est celui des équipements hyperfréquence bande étroite ou large bande, les boîtiers étant utilisables dans toutes les applications haute fréquence, même celles avec des spécifications élevées d'intégrité du signal.

Les seules technologies de packaging hyperfréquence résistant à l'humidité reposent sur l'emploi de matériaux inorganiques ou sur l'encapsulation des composants par des résines organiques injectées. Les solutions inorganiques font notamment appel à des boîtiers hermétiques métalliques à perles de verre pour les entrées/sorties ou céramiques.

Les solutions utilisant des matériaux inorganiques présentent plusieurs inconvénients. On obtient notamment :
- Des boîtiers chers et lourds, du fait des matériaux utilisés, métal ou céramique ;
- Des solutions encombrantes, utilisant notamment des boîtiers à cavités internes, très souvent avec des interconnexions périphériques ;
- Des solutions dont la fiabilité de report, dans l'équipement concerné, est généralement problématique, du fait de différences de coefficient de dilatation avec les circuits imprimés sur lesquels elles sont assemblées.

Dans le cas des packagings organiques injectés, on aboutit à des objets qui sont intrinsèquement non blindés électriquement et qui ne peuvent donc pas être utilisés tels quels dans des équipements complexes où la diaphonie est un paramètre critique. Le boîtier usuellement rencontré est le boîtier dit QFN (« Quad Flat No-Lead ») qui a des entrées et sorties généralement périphériques.

Il y a un besoin pour des boîtiers compacts répondant aux contraintes suivantes :
- Protéger les fonctions encapsulées de l'humidité, notamment pour prendre en compte toutes les technologies MMIC (Microwave Monolithique Integrated Circuit) ;
- Obtenir une bonne fiabilité des reports ;
- Maintenir la possibilité de changer les boîtiers sur la carte ;
- Etre aptes à dissiper les calories ;
- Avoir une capacité à pouvoir faire du 3D, c'est-à-dire suivant les architectures, même avec des boîtiers ultra compacts, empiler des fonctions hyperfréquence suivant la densité d'intégration des puces utilisées.

Les applications hyperfréquence requièrent l'usage de semi-conducteurs III-V à haute mobilité de charges. Ces composants fonctionnent en mode analogique et sont donc très sensibles à la qualité des interconnexions qu'elles utilisent ainsi qu'aux interférences qu'elles peuvent rencontrer. De plus, ceux-ci fonctionnant à des tensions et des courants significatifs, les constituants électroniques (transistors, capacités, résistances ...) peuvent subir des phénomènes de corrosion lorsque ceux-ci sont en fonctionnement, par exemple des corrosions électrochimiques par différence de potentiel de Nernst.

Pour éviter tout problème de fiabilité les industriels ont d'abord développé des boîtiers hermétiques utilisant des matériaux inorganiques (métaux ou céramiques comme indiqué précédemment) qui sont lourds et encombrants. Afin de réduire la masse, le volume et le prix de fabrication des packagings hyperfréquences, des boîtiers plastiques ont commencé à être développés avec une perte de performances électromagnétiques importante mais acceptable pour les applications en bande étroite comme la téléphonie mobile.

Le domaine du packaging électronique a fait l'objet de nombreux développements. Le boîtier de type BGA (Ball Grid Array) à interconnexions surfaciques a été développé en réponse à la technologie QFP (Quad Flat Pack) à interconnexions périphériques afin d'accroître la densité d'interconnexions. Ce type de boîtiers BGA a connu un grand essor pour les applications numériques à base de semi-conducteurs en silicium.

Dans le domaine des packagings organiques hyperfréquence, de nombreuses solutions ont également été développées. Parmi ces solutions, on peut citer la technologie CSP (Chip Scale Package) pour des applications à bande étroite avec une fréquence opérationnelle inférieure à 2,17 GHz. Des boîtiers plastiques susceptibles de gérer des dissipations thermiques de l'ordre de 60 W à 100 W ont aussi été mis au point pour des applications allant jusqu'à 2,17 GHz. Il existe des boîtiers plastiques pour des applications hautes fréquences, jusqu'à 35 GHz, en bande étroite de type QFN. Des boîtiers plastiques de type QFN ou TSOP (Thin Small Outline Package) fonctionnent jusqu'à 12 GHz. Un boîtier à cavité utilisant un matériau thermoplastique dit LCP (Liquid Crystal Polymer) a été développé à la fin des années 2000 pour des applications à hautes fréquences. Durant la même période le concept de packaging pour applications hyperfréquence, en technologie LTCC (Low Température Cofired Ceramic) et en matériaux organiques LCP, a vu le jour. Le boîtier de type QFP (Quad Flat Pack), à cavité, a permis l'encapsulation avec des performances satisfaisantes, d'une fonction large bande.

Par ailleurs, des demandes de brevet FR 2 849 346 et FR 2877537 décrivent une technologie de packaging organique BGA à cavité.

Comme cela a été indiqué précédemment, les seules technologies de packaging hyperfréquence résistantes à l'humidité compatibles de tous les MMIC reposent sur l'emploi de matériaux inorganiques (boîtiers métalliques à perles de verre pour les entrées et sorties ou boîtiers céramiques), ou sur l'encapsulation des composants par des résines organiques injectées. Les solutions à base de matériaux inorganiques conduisent à l'utilisation de boîtiers chers et lourds, et sont encombrantes, en particulier en raison des cavités internes et des interconnexions périphériques. Les solutions à base de matériaux organiques ont l'inconvénient majeur de ne pas être blindés électriquement, et ne sont donc pas utilisables dans des équipements complexes où la diaphonie est un paramètre critique sans cloisonnement complémentaire.

Un document US 5 796 170 A décrit un composant de type BGA pour circuit intégré. Un document US 2006/042078 A1 divulgue un procédé d'encapsulation d'un composant électronique dans un circuit imprimé. Un document US 2008/017409 A1 divulgue également un procédé d'encapsulation d'un composant électronique dans un circuit imprimé. Un document US 2011/147920 A1 divulgue un appareil d'intégration de composants dans des systèmes sur boîtier a petit facteur de forme.

Un but de l'invention est notamment de pallier les inconvénients précités, en permettant notamment la réalisation de boîtiers de composants électroniques peu encombrants, économiques et aptes à être blindés. A cet effet, l'invention a pour objet un procédé tel que défini par les revendications.

D'autres caractéristiques et avantages de l'invention apparaîtront à l'aide de la description qui suit, faite en regard de dessins annexés qui représentent :
- La figure 1, un exemple de réalisation d'un composant hyperfréquence selon l'invention ;
- La figure 2, un exemple de connexion électrique utilisée dans un composant fabriqué selon le procédé de l'invention revendiquée ;
- La figure 3, un exemple de blindage électrique d'un composant fabriqué selon le procédé de l'invention revendiquée ;
- La figure 4, une illustration des étapes de réalisation possibles d'un dispositif selon l'invention.

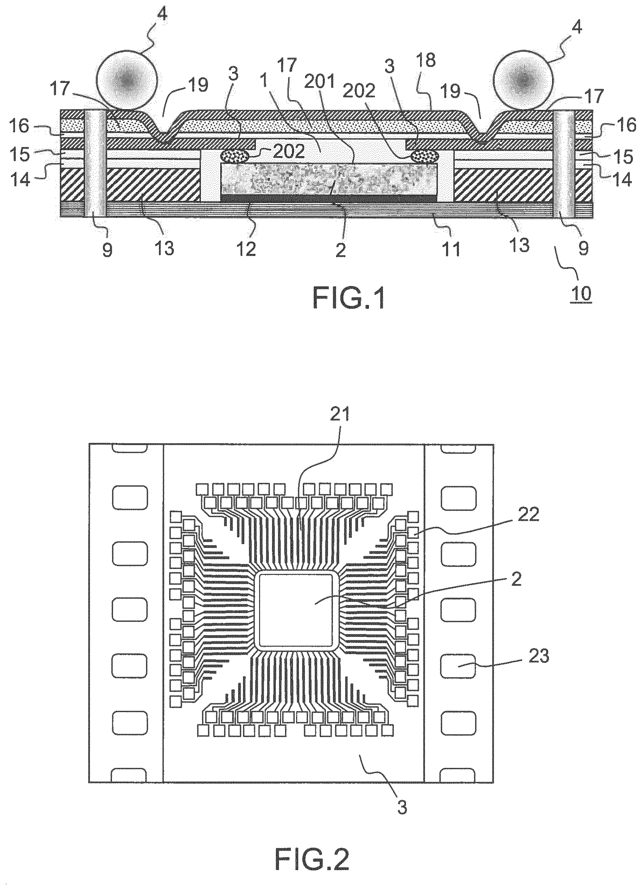

La figure 1 illustre par une vue en coupe un exemple de réalisation d'un composant hyperfréquence 10 fabriqué selon le procédé de l'invention revendiquée. Le principe de l'invention repose sur l'utilisation d'un matériau thermoplastique 1 du type LCP (Liquid Crystal Polymer), matériau étanche à l'humidité, de faible perméabilité à la vapeur d'eau, remplissant une cavité préexistante dans laquelle est placé au moins un circuit hyperfréquence 2. Par la suite, à titre d'exemple, on décrit un composant hyperfréquence 10 comportant un seul circuit hyperfréquence 2. Un composant fabriqué selon le procédé de l'invention revendiquée peut bien sûr comporter plusieurs puces électroniques ainsi que des composants passifs.

Le boîtier d'un composant selon l'invention n'a donc pas de cavité. Le circuit hyperfréquence 2, par exemple une puce du type MMIC, ainsi encapsulé est recouvert d'un matériau étanche à l'humidité, avantageusement du matériau LCP, intrinsèquement peu hydrophile. La déformation de ce matériau 1 permet le remplissage de la cavité et permet d'obtenir des empilements homogènes et résistants à la pénétration de l'eau. De même à sa température de fusion, le LCP devient quasi-liquide et n'exerce plus de contrainte mécanique. Cette propriété permet la conservation de l'intégrité de structures hyperfréquences fragiles telles que les « ponts à air » que l'on trouve sur beaucoup de MMIC.

Avantageusement, l'invention utilise par exemple à l'intérieur du boîtier une couche d'interconnexions 3 présentant une certaine souplesse, de type TAB, pour interconnecter le circuit hyperfréquence 2 aux connexions externes 4, de type BGA. Dans un mode de connexion de type TAB (« Tape Automated Bonding »), les liaisons d'interconnexion sont des pistes conductrices placées sur un film diélectrique, par exemple en polyimide. Ce type de connexion permet de maîtriser la qualité électrique des connexions réalisées et ainsi un fonctionnement en haute fréquence et dans une large bande.

Le composant hyperfréquence 10 de la figure 1 comporte une plaque métallique 11 formant drain thermique. Le circuit hyperfréquence 2 est fixé sur cette plaque 11 par collage ou par brasure 12, la colle ou la brasure formant également couplage thermique.

Le circuit hyperfréquence 2 est placé dans une cavité préexistante délimitée latéralement par une première couche 13, en matériau thermodurcissable rigide. Cette première couche 13 est surmontée d'une ou plusieurs couches 14, 15 en matériau thermoplastique LCP. Les couches thermoplastiques 14, 15 supportent la couche 3 de type TAB, plus précisément les films diélectriques équipés de pistes conductrices. Cette couche 3 permet d'interconnecter le circuit hyperfréquence 2 avec d'autres circuits éventuels disposés à l'intérieur du boîtier ou avec les connexions d'entrées et de sorties, notamment vers des billes de brasures 4, le boîtier étant du type BGA.

Ces couches en matériau organique 13, 14, 15 sont recouvertes d'une couche supérieure 17, également en matériau organique.

La cavité délimitée par ces couches 13, 14, 15, 17 enferme le circuit hyperfréquence. Elle est remplie par le fluage du matériau thermoplastique LCP 1 de façon à encapsuler le circuit hyperfréquence comme décrit précédemment.

Le film 3 de l'interconnexion de type TAB est par exemple recouvert d'une couche 16 en matériau thermoplastique LCP.

L'ensemble est recouvert d'une couche externe composée de la couche 17 supérieure, en matériau thermodurcissable rigide, recouverte d'une couche métallique 18, en cuivre par exemple. Les couches thermoplastiques 16, 17 surmontant l'interconnexion 3 de type TAB sont percée en plusieurs endroits, par exemple par faisceau laser, de façon à accueillir des enfoncements 19 en regard de perforations réalisées sur l'interconnexion 3.

La figure 2 illustre une couche de connexion de type TAB telle qu'utilisée dans le composant de la figure 1. Cette couche de connexion est composée d'un film plastique 3 sur lequel sont placées des pistes conductrices 21 reliant des points de connexion 202 du circuit hyperfréquence 2, comme le montre la figure 1, à des points d'interconnexions 22 situés sur le film plastique. Ces points d'interconnexions 22 sont eux-mêmes reliés par un réseau de pistes ou de vias à d'autres circuits actifs ou passifs, ou encore aux entrées et sorties du composant.

Le film 3 comporte également des perforations 23 dans lesquelles viennent se positionner les enfoncements 19. Avantageusement, la couche de connexion 3 présente une courbure permettant de compenser la double contrainte mécanique provenant d'une part de l'enfoncement 19 et d'autre part de la face arrière 201 de la puce 2 constituant le circuit hyperfréquence.

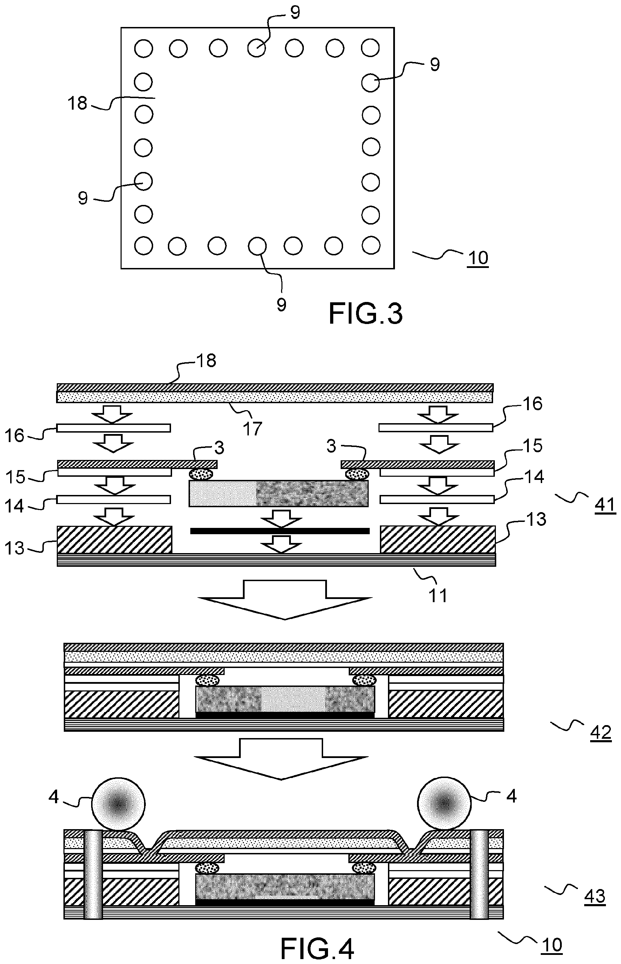

On revient à la figure 1. Des trous métallisés 9 traversent la périphérie du composant pour relier électriquement le plan conducteur 11 formant le drain avec le plan conducteur 18 supportant les billes de connexion externe 4. Ces trous sont disposés sur toute la périphérie du composant, par exemple de façon régulière, pour former une cage de Faraday délimitée par les plans conducteurs 11, 18 et par le réseau de trous métallisés 9. La figure 3 illustre, par une vue de dessus du composant 10, un exemple de disposition de ces trous 9 à la périphérie. On obtient ainsi un packaging intrinsèquement blindé par la réalisation d'une cage de Faraday interne couplé à un mode d'interconnexion en mode quasi coaxial.

La figure 4 illustre un exemple de procédé de packaging selon l'invention permettant notamment d'obtenir un composant hyperfréquence tel que décrit précédemment.

Le principe de packaging d'un composant fabriqué selon le procédé de l'invention revendiquée repose sur l'utilisation de couches en matériau thermoplastique LCP. Par sa nature thermoplastique, le matériau LCP se déforme, flue, lors de sa mise en oeuvre vers 280°C pour conformer et remplir la cavité préexistante.

Dans une première phase de réalisation 41, on effectue l'assemblage des différentes parties constitutives du composant 10. La couche rigide 13 est fixée sur le plan métallique 11 formant support. Le plan métallique peut être également formé d'une couche de matériau thermodurcissable cuivrée. La puce 2 est collée par sa face arrière sur ce plan 11 au moyen d'une couche 12, de colle thermique ou d'alliage de brasure du type AuSn par exemple. D'autres éléments actifs ou passifs constitutifs du composant 10 peuvent être collés ou brasés. Dans le présent exemple de réalisation, le composant hyperfréquence comporte une seule puce 2.

Une ou plusieurs couches 3, 14, 15, 16 sont empilées sur la couche rigide 13 pour former une cavité destinée à être remplie par le matériau thermoplastique LCP 1 encapsulant la puce 2. La surface occupée par la cavité contient le ou les circuits/éléments constituant la fonction électronique du composant, ces circuits et/ou éléments étant destinés à être encapsulés par le matériau LCP lors du remplissage de la cavité.

Parmi ces couches empilées, il y des couches de collage en matériau thermoplastique, notamment les couches 14, 15 et 16, et des couches fonctionnelles, par exemple la couche d'interconnexion 3. Avant le remplissage de la cavité la couche d'interconnexion 3, de type TAB, est en effet positionnée. Elle est connectée au préalable aux points de connexions 202 de la puce 2, la puce étant fixée sur le support 11 une fois cette opération de connexion effectuée.

L'ensemble de ces couches, y compris la cavité remplie, sont recouvertes de la couche externe composée d'une couche thermoplastique 17 recouverte d'une couche conductrice 18, en cuivre par exemple.

On peut si nécessaire réaliser des interconnexions verticales dans cet empilage par perçage laser ou mécanique, et par métallisation chimique ou électrolytique, à différentes étapes de l'empilement.

Dans une deuxième phase 42, on effectue le pressage à température de fusion du matériau LCP pour coller toutes les couches entre elles et combler tous les interstices et défauts de planéité de l'empilage. Avantageusement, la couche rigide 13 forme une butée mécanique lors du pressage qui protège la puce, en préservant son intégrité.

Dans une troisième phase on finalise la réalisation du composant. En particulier, on effectue le perçage des trous traversants 9 pour créer la cage de Faraday protégeant le ou les circuits internes des interférences. On effectue également le billage du boîtier selon un procédé standard, du type sérigraphie de pâte à braser, positionnement des billes 4 et re-fusion en four. Les connexions des billes 4 avec les circuits internes, et notamment avec la couche d'interconnexions 3 peuvent être réalisées par des pistes conductrices obtenues par sérigraphie sur les couches intermédiaires ou sur la couche supérieure 17 ainsi que par un réseau de vias traversant ces couches en direction des billes. Les billes 4 peuvent également être reliées électriquement à un potentiel de masse.

Un composant hyperfréquence 10 tel que décrit précédemment peut être fabriqué en série. A cet effet, on prévoit des empilages de couches de longueur donnée formant une rangée de motifs, chaque motif correspondant à un composant. La bande de motifs obtenue est ensuite découpée pour obtenir les composants individuels.

La figure 4 illustre le principe de réalisation d'un composant fabriqué selon le procédé de l'invention revendiquée. La solution selon l'invention est basée sur la mise en oeuvre d'une technologie de packaging organique surfacique, de type BGA, sans cavité réalisé par une méthode de fabrication.

La suppression de la cavité, originellement définie pour le placement des puce ou semi-conducteur 2 ou éléments passifs, permet avantageusement d'éviter la pénétration de l'humidité sous forme de liquide ou de vapeur) au niveau de ceux-ci, et donc de supprimer tout problème de corrosion par effet électrochimique, au niveau des empilages métalliques des puces électroniques en présence d'un électrolyte eau. L'utilisation du matériau thermoplastique LCP permet d'obtenir un boîtier beaucoup plus résistant à l'humidité par rapport à tous les polymères utilisés dans l'art antérieur.

La suppression de la cavité interne du boîtier permet de le compacter significativement, en supprimant notamment des murs de cavité définissant la surface d'implantation des fonctions électroniques. On peut ainsi obtenir un composant 10 très compact.

La structure de type circuit imprimé permet la réalisation d'une structure de type « cage de Faraday », par réalisation de perçage métallisés 9 connectant deux plans métalliques 11, 18 positionnées l'un au dessous et l'autre au dessus de la fonction électronique 2. Cette fonction est ainsi isolée électriquement, ce qui élimine les problèmes de diaphonie entre le composant et d'autres composants éventuels.

La technique de type circuit imprimé permet également d'empiler les fonctions électronique dans l'épaisseur de la structure formant boîtier.

Enfin, la technique de type circuit imprimé permet d'atteindre des densités d'intégration maximales, permettant d'empiler des couches fonctionnelles et non fonctionnelles les unes par-dessus les autres. L'empilement d'au moins une couche 13 thermodurcissable rigide garantit le maintien mécanique de l'ensemble de la structure constituant le composant.

Le mode d'interconnexion surfacique, de type BGA, permet la conception des entrées et sorties du composant de telle manière que celles-ci puissent véhiculer des signaux haute fréquence blindés et insensibles aux perturbations extérieures, en particulier grâce à la structure quasi coaxiale avec un blindage périphérique 9, constitué par des connexions de masse. Les couches intermédiaires 14, 15, 16 sont différents de la première couche 13 et de la couche supérieure 17. Ces couches 14, 15, 16 ont notamment pour fonction de participer au collage de la structure multicouche ainsi réalisée.

Le fluage du LCP, principalement en couches 14 et 16, pendant le pressage du « sandwich » doit permettre d'obtenir ce résultat. La couche 15 étant constituée avec un « stratifié » LCP ou autre qui ne fondera pas lors du pressage, contrairement aux couches 14 et 16 qui ont un point de fusion plus bas.

Pour ce faire, le routage de signaux n'est réalisé qu'après pressage, soit par vias laser 19 ou trous métallisés 9. Dans cette approche, les modifications dimensionnelles (variations d'épaisseurs) ne modifient pas les connexions puisqu'elles sont créées a posteriori, et leur conception peut être ajustée à ces variations.

La couche supérieure 17, pouvant être constituée dans un matériau similaire à celui de la couche 13, doit permettre le maintien de la planéité du boîtier.

L'invention a été décrite pour la réalisation d'un composant hyperfréquence, mais elle peut s'appliquer plus généralement pour un composant électronique comportant un ou plusieurs circuits électroniques à semi-conducteurs, accompagnés par exemple de circuits passifs. La fonction électronique constituée de ces éléments est alors encapsulée dans un packaging tel que décrit précédemment.

## Revendications

1. Procédé de packaging d'au moins un circuit électronique, ledit procédé comportant au moins :
- une première phase (41) dans laquelle ledit circuit électronique est fixé sur un support métallique (11) et plusieurs couches en matériaux organiques sont empilées sur ledit support (11) pour former une cavité dans laquelle est enfermé ledit circuit électronique (2), la couche inférieure (13) de l'empilement des plusieurs couches en matériau organique étant en contact avec ledit support (11) et la couche supérieure (17) de cet empilement recouvrant la cavité, la couche inférieure et la couche supérieure étant en matériau thermodurcissable rigide, des couches organiques (14, 16) de l'empilement de couches en matériaux organiques intercalées entre la couche inférieure et la couche supérieure étant en matériau thermoplastique LCP (1), ladite cavité étant remplie par fluage du matériau thermoplastique LCP (1) et la couche supérieure (17) étant recouverte d'une couche métallique (18) ;
- une deuxième phase (42) dans laquelle, on effectue le pressage desdites couches en matériaux organiques sur ledit support à température de fusion du matériau thermoplastique LCP (1) pour coller toutes les couches entre elles, les couches en matériau thermoplastique LCP ayant pour fonction de participer au collage de toutes les couches,
le procédé étant **caractérisé en ce que**,
dans une troisième phase (43), un réseau de trous métallisés (9) est réalisé sur la périphérie de l'empilage desdites couches, lesdits trous (9) reliant électriquement ledit support (11) et ladite couche métallique (18) de façon à former une cage de Faraday autour dudit circuit électronique.

2. Procédé de packaging selon la revendication 1, **caractérisé en ce qu'**une couche d'interconnexion (3) de type TAB est empilée avec lesdites couches, ladite couche d'interconnexion (3) étant préalablement connectée au circuit électronique (2).

3. Procédé de packaging selon la revendication 1 ou 2, **caractérisé en ce que** dans la troisième phase (43), un réseau de billes est fixé sur ladite couche métallique (18), des billes étant reliées électriquement audit circuit électronique.

4. Procédé de packaging selon l'une quelconque des revendications précédentes, **caractérisé en ce que** ledit circuit électronique est un circuit hyperfréquence.

5. Procédé selon l'une quelconque des revendications précédentes, **caractérisé en ce que** ledit circuit électronique est un circuit hyperfréquence de type MMIC.

## Patentansprüche

1. Verfahren zum Verpacken mindestens einer elektronischen Schaltung, wobei das Verfahren mindestens Folgendes umfasst:
- eine erste Phase (41), in der die elektronische Schaltung auf einem Metallträger (11) befestigt wird und mehrere Schichten aus organischen Materialien auf dem Träger (11) gestapelt werden, um einen Hohlraum zu bilden, in dem die elektronische Schaltung (2) eingeschlossen ist, wobei die untere Schicht (13) des Stapels der mehreren Schichten aus organischem Material mit dem Träger (11) in Kontakt steht und die obere Schicht (17) dieses Stapels den Hohlraum bedeckt, wobei die untere Schicht und die obere Schicht aus einem steifen wärmehärtbaren Material bestehen, wobei organische Schichten (14, 16) des Stapels aus Schichten aus organischen Materialien, die zwischen der unteren Schicht und der oberen Schicht zwischengeschaltet sind, aus einem thermoplatischen Material LCP (1) bestehen, wobei der Hohlraum durch Kriechen des thermoplastischen Materials LCP (1) gefüllt ist und die obere Schicht (17) mit einer Metallschicht (18) bedeckt ist;
- eine zweite Phase (42), in der die Schichten aus organischen Materialien auf dem Träger bei Schmelztemperatur des thermoplastischen Materials LCP (1) gepresst werden, um alle Schichten miteinander zu verkleben, wobei die Schichten aus thermoplastischem Material LCP die Funktion erfüllen, an der Verklebung aller Schichten mitzuwirken,
wobei das Verfahren **dadurch gekennzeichnet ist, dass**
in einem dritten Schritt (43) ein Netzwerk von metallisierten Löchern (9) am Umfang des Stapels der Schichten hergestellt wird, wobei die Löcher (9) den Träger (11) und die Metallschicht (18) elektrisch verbinden, um einen Faraday-Käfig um die elektronische Schaltung herum zu bilden.

2. Verpackungsverfahren nach Anspruch 1, **dadurch gekennzeichnet, dass** eine Verbindungsschicht (3) vom Typ TAB mit den Schichten gestapelt wird, wobei die Verbindungsschicht (3) zuvor mit der elektronischen Schaltung (2) verbunden wird.

3. Verpackungsverfahren nach Anspruch 1 oder 2, **dadurch gekennzeichnet, dass** in der dritten Phase (43) eine Anordnung von Kugeln auf der Metallschicht (18) befestigt wird, wobei Kugeln elektrisch mit der elektronischen Schaltung verbunden werden.

4. Verpackungsverfahren nach einem der vorhergehenden Ansprüche, **dadurch gekennzeichnet, dass** die elektronische Schaltung eine Mikrowellenschaltung ist.

5. Verfahren nach einem der vorhergehenden Ansprüche, **dadurch gekennzeichnet, dass** die elektronische Schaltung eine Mikrowellenschaltung vom Typ MMIC ist.

## Claims

1. A method for packaging at least one electronic circuit, the method comprising at least:
- a first phase (41) in which said electronic circuit is fixed to a metal support (11) and several layers of organic materials are stacked on said support (11) to form a cavity in which said electronic circuit (2) is enclosed, the lower layer (13) of the stack of several layers of organic material being in contact with said support (11) and the upper layer (17) of this stack covering the cavity, the lower layer and the upper layer being made of rigid thermosetting material, organic layers (14, 16) of the stack of layers of organic materials which are interposed between the lower layer and the upper layer being made of thermoplastic material LCP (1), said cavity being filled by means of creep of the thermoplastic material LCP (1) and the upper layer (17) being covered with a metal layer (18);
- a second phase (42) in which said layers of organic materials are pressed onto said support at a melting temperature of the thermoplastic material LCP (1) in order to adhesively bond all the layers together, the layers of thermoplastic material LCP having the objective of contributing to the adhesive bonding of all the layers,
the method being **characterised in that**,
in a third phase (43), a network of metallised holes (9) is produced on the periphery of the stack of said layers, said holes (9) electrically connecting said support (11) and said metal layer (18) in order to form a Faraday cage around the electronic circuit.

2. The packaging method according to claim 1, **characterised in that** an interconnection layer (3) of the TAB type is stacked with said layers, said interconnection layer (3) being connected to the electronic circuit (2) beforehand.

3. The packaging method according to claim 1 or 2, **characterised in that**, in the third phase (43), a network of balls is fixed to said metal layer (18), balls being electrically connected to said electronic circuit.

4. The packaging method according to any one of the preceding claims, **characterised in that** said electronic circuit is a hyperfrequency circuit

5. The method according to any one of the preceding claims, **characterised in that** said electronic circuit is a hyperfrequency circuit of MMIC type.
